# EUROPÄISCHE PATENTANMELDUNG

(11) **EP 4 621 111 A1**
(43) Veröffentlichungstag der Anmeldung: **24.09.2025**
(21) Anmeldenummer: 24164119.0
(22) Anmeldetag: 18.03.2024
(51) Int. Cl.: C30B 15/04, C30B 27/02, C30B 29/06

(54) **VERFAHREN ZUM HERSTELLEN EINES HOCHDOTIERTEN MONOKRISTALLINEN KRISTALLS AUS SILICIUM**

(71) Anmelder: Siltronic AG, 81677 München (DE)
(72) Erfinder: Auer, Clemens, 5120 St. Pantaleon (AT)

(57) **Zusammenfassung**

Verfahren zum Ziehen eines Kristalls aus Silicium mit einem Widerstand von kleiner als 2 mOhmcm nach dem Czochralski-Verfahren enthaltend die Schritte das in Kontaktbringen eines Impflingskristalls (**102**) mit einer dotierten Schmelze aus Silicium (**105**) in einer Kristallziehanlage, wobei das Innere der Kristallziehanlage mit einem ersten Spülgas gespült wird; das Ziehen eines Dünnhalses (**103**) enthaltend das Reduzieren des Durchmessers des Impflingskristalls (**102**); das Erweitern des Durchmessers des Dünnhalses (**103**) zu einem Anfangskonus (**104**) bis zu einem Zieldurchmesser; und das Ziehen eines zylindrischen Teils des Kristalls mit dem Zieldurchmesser, dadurch gekennzeichnet, dass während des Ziehens des Dünnhalses der Gasraum um den Dünnhals (**103**) mit einer Entfernung E von mehr als 2 cm normal zur Oberfläche des Dünnhalses (**103**) mit einem zweiten Spülgas gespült wird.

## Beschreibung

Gegenstand der Erfindung ist ein Verfahren zur Herstellung eines monokristallinen Stabes aus Silizium, insbesondere eines dotierten monokristallinen Stabes aus Silicium mittels des Verfahrens nach Czochralski.

Einkristallines Silizium, das als Ausgangsmaterial für die meisten Verfahren zur Herstellung von elektronischen Halbleiterbauelementen ist, wird üblicherweise nach dem sogenannten Czochralski-Verfahren ("CZ") hergestellt. Bei diesem Verfahren wird polykristallines Silizium ("Polysilizium") in einen Tiegel gegeben und geschmolzen, ein Impfkristall wird mit dem geschmolzenen Silizium in Kontakt gebracht und ein Einkristall wird durch langsame Extraktion gezüchtet.

Der Tiegel besteht üblicherweise aus einem Siliziumdioxid enthaltenden Material wie Quarz. Er wird in der Regel mit Bruchstücken und/oder mit Granulat aus polykristallinem Silizium gefüllt, das mit Hilfe eines um den Tiegel herum angeordneten Seitenheizers und eines unter dem Tiegel angeordneten Bodenheizers geschmolzen wird. Nach einer Phase der thermischen Stabilisierung der Schmelze wird ein ein-kristalliner Impfkristall in die Schmelze getaucht und angehoben. Dabei kristallisiert Silizium am von der Schmelze benetzten Ende des Impfkristalls. Die Kristallisations-geschwindigkeit wird im Wesentlichen durch die Geschwindigkeit beeinflusst, mit der der Impfkristall angehoben wird (Kristallhubgeschwindigkeit) und von der Temperatur an der Grenzfläche, an der geschmolzenes Silizium kristallisiert. Durch geeignete Steuerung dieser Parameter wird zunächst ein als Dünnhals ("neck") bezeichneter Abschnitt gezogen, um Versetzungen zu beseitigen, dann ein konusförmiger Abschnitt des Einkristalls und schließlich ein zylindrischer Abschnitt des Einkristalls, von dem später die Halbleiterscheiben abgetrennt werden.

Bei den meisten Anwendungen wird der Schmelze eine gewisse Menge an Dotierstoff zugegeben, um einen gewünschten spezifischen Widerstand im Siliziumkristall zu erreichen. Konventionell wird der Dotierstoff aus einem Einfülltrichter, der sich einige Meter über dem Niveau der Siliziumschmelze befindet, in die Schmelze eingebracht. Diese Vorgehensweise ist jedoch für flüchtige Dotierstoffe ungünstig, da solche Dotierstoffe dazu neigen, unkontrolliert in die Umgebung zu verdampfen, was zur Bildung von Oxidpartikeln (d. h. Suboxiden) führen kann, die in die Schmelze fallen und in den wachsenden Kristall eingebaut werden können. Diese Partikel können als heterogene Keimbildungsstellen wirken und letztlich zum Versagen des Kristallziehprozesses durch Verursachen von zum Beispiel Versetzungen führen.

Zur Herstellung von Halbleiter-Leistungs-Bauelementen werden als Rohstoff Einkristalle aus Silizium benötigt, die vergleichsweise viel Dotierstoff vom n-Typ enthalten und dem nach einen sehr kleinen spezifischen Widerstand (kleiner als 2 mOhmcm) aufweisen. Die Zugabe einer hohen Menge an Dotierstoff (in der Regel Phosphor oder Arsen) kann jedoch auch dazu führen, dass der Kristallziehprozess durch das Auftreten von Versetzungen versagt.

Die WO 2009/113441 A1 beschreibt ein Verfahren und eine Vorrichtung zum Dotieren von Silicium, wobei Dotierstoff sublimiert wird und gasförmig kontinuierlich der Schmelze zugeführt wird.

In der WO 2014/141 309 A1 wird eine Vorrichtung zum Kristallziehen beschrieben, die ein Zufuhrsystem für Dotierstoff enthält, das eine Dotierstoffleitung enthält, die mit einem speziellen Kammersystem ausgestattet ist, so dass fester Dotierstoff nicht in die Schmelze fallen, gasförmiger Dotierstoff aber zur Schmelze gelangen kann.

Problematisch beim Ziehen von Kristallen aus einer hochdotierten Schmelze ist, dass diese Kristalle oft Versetzungen aufweisen, die dazu führen, dass diese Kristalle nicht für den ursprünglichen Zweck brauchbar sind. Als hochdotierte Schmelze wird dabei eine Schmelze aus Silicium verstanden, aus der Stäbe mit einem Widerstand von 2 mOhmcm oder kleiner gezogen werden können.

Aufgabe der vorliegenden Erfindung ist es, ein Verfahren zu Herstellung von monokristallinem Silicium, das einen minimalen spezifischen Widerstand von kleiner als 2 mOhmcm aufweist, bereitzustellen, bei dem keine Versetzungen des Kristalls auftreten.

Die Aufgabe wird gelöst durch die in den Ansprüchen beschriebenen Verfahren.

### Beschreibung der Figuren

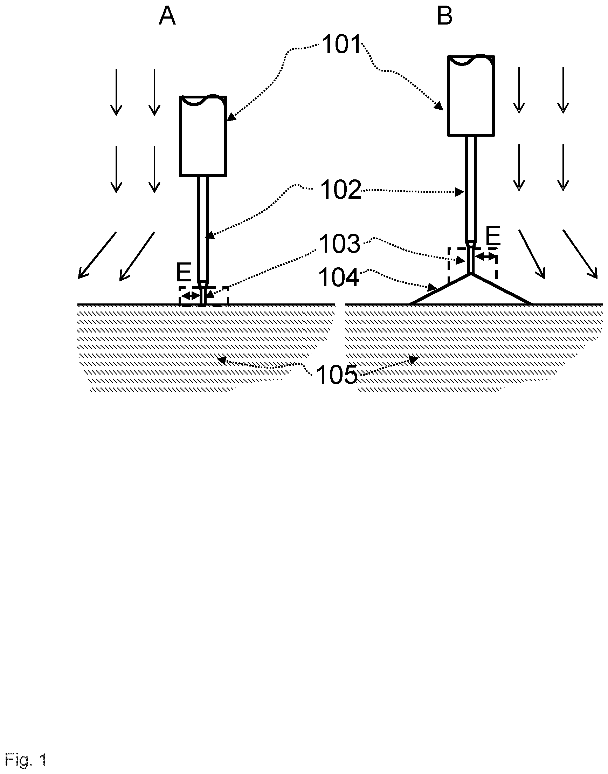

**Fig. 1** zeigt zwei zeitlich unterschiedliche Situationen A und B in der Kristallziehanlage. Die eingezeichneten Pfeile verdeutlichen die Flussrichtung des ersten Spülgases, das gemäß dem Stand der Technik verwendet wird.
   In beiden Situationen wird ein Impflingskristall **(102)** an einem Impflingshalter **(101)** über der Schmelze **(105)** positioniert. Bei der Situation A (linke Seite) wird gerade ein sogenannter Dünnhals (engl. dash neck) **(103)** gezogen, während bei der Situation B der Durchmesser des gezogenen Dünnhalses zu einem Anfangskonus **(104)** erweitert wird. Der in beiden Situationen gezeigte Gasraum um den Dünnhals mit einer Entfernung **E** normal zur Oberfläche des Dünnhalses ist der Bereich, der erfindungsgemäß mit einem zweiten Spülgas gespült wird.

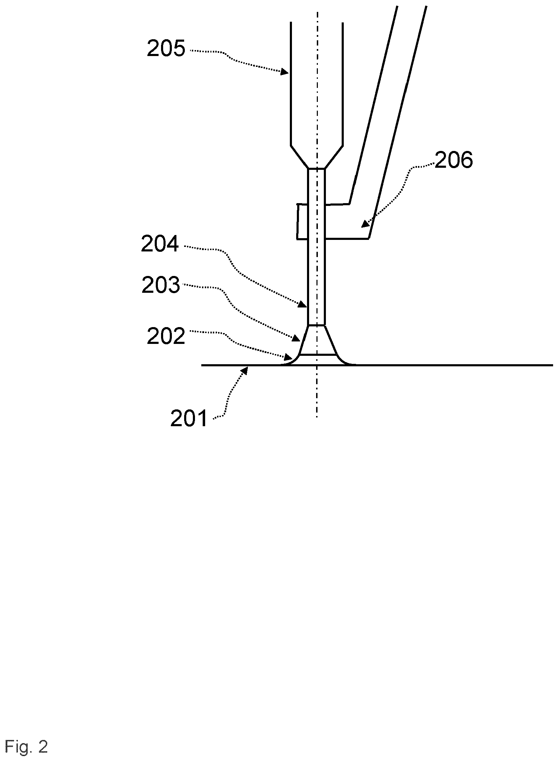

**Fig. 2** zeigt einen Impflingskristall **(205),** der zu einem Dünnhals (204) gezogen wird. Es wird gerade der Zeitpunkt gezeigt, an dem begonnen wird den Durchmesser des Dünnhalses zu einem Anfangskonus **(203)** zu erweitern. Gezeigt ist ferner im Detail der Meniskus **(202),** der sich ausbildet, wenn das monokristalline Silicium mit der Schmelze **(201)** kontakt hat. Die gezeigte Lanze **(206)** wird dabei verwendet, um den Gasraum um den Dünnhals mit einem zweiten Spülgas zu spülen. Die Lanze ist dabei so angebracht, dass sie zusammen mit dem Impflingskristall nach oben und unten verfahrbar ist.

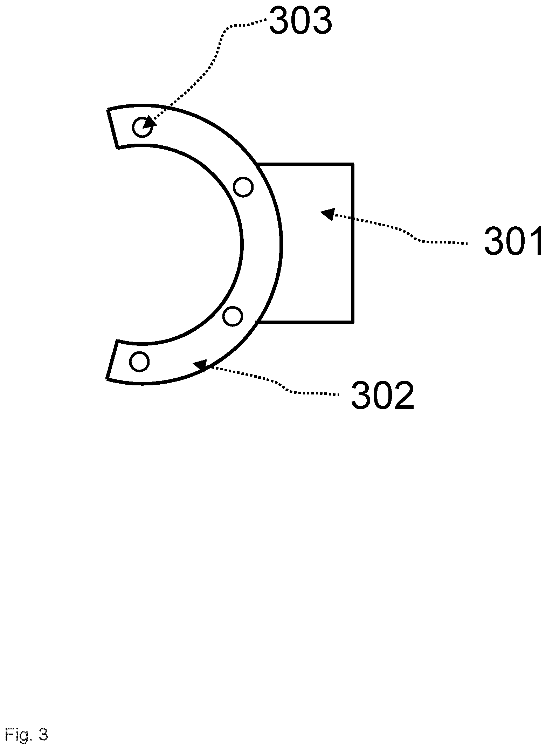

**Fig. 3** zeigt eine erfindungsgemäße Ausprägung einer Lanze, die dafür geeignet ist, den Dünnhals zu umfassen. Dabei wird das untere Ende der Lanze (301) mit einer gebogenen Vorrichtung (302) ausgestattet, die es erlaubt den Dünnhals zu umfassen. Die eingelassenen Öffnungen (303) sorgen dafür, dass das zweite Spülgas den Bereich um den Dünnhals spülen kann.

### Detaillierte Beschreibung erfindungsgemäßer Ausführungsbeispiele

Der Erfinder hat nach langen Beobachtungen erkannt, dass beim Ziehen von hochdotierten Einkristallen nach dem Czochralski-Methode relativ häufig Versetzungen auftreten. Der Dotierstoff beinhaltet dabei aus der Schmelze leicht flüchtige Dotierstoffe in hoher Konzentration. Insbesondere sind dies die Dotierstoffe Phosphor und/oder Arsen. Als hohe Konzentration wird dabei verstanden als die Menge Dotierstoff, die erforderlich ist, um einen Kristall mit einem maximalen Widerstand von 2 mOhmcm zu erhalten.

Der Erfinder hat auch erkannt, dass die genannten Versetzungen meist früh im Kristallziehprozess auftreten. Der Zeitbereich wurde identifiziert als die Phase des Kristallziehens, bei der der Anfangskonus des Kristalls gezogen wird, wenn also der Durchmesser des Impflings zum Zieldurchmesser erweitert wird.

Aus der Patentanmeldung EP 4 130 348 A1 ist beispielsweise bekannt, dass Partikel, die während des Kristallziehens generiert werden, auf die Schmelze fallen und dort in der Nähe des Kristallrandes zu einer Versetzung führen können. Ein vermehrtes Auftreten von Versetzungen gerade im Anfangsbereich ist damit aber nicht oder nur schwer zu erklären.

Der Erfinder geht aber davon aus, dass die Ursache für die auftretenden Versetzungen woanders zu suchen sind, da der Mechanismus, der in EP 4 130 348 A1 beschrieben wird, auch in einer späteren Kristallziehphase auftreten kann, aber das beschriebene Problem besonders im ersten Teil des Kristallziehens beobachtet werden kann.

Der Erfinder weiß, dass die verwendeten Dotierstoffe für hochdotierte Schmelzen die Eigenschaft haben, während des Kristallziehens auszudampfen.

Wird nun ein Kristall aus der Schmelze gezogen, baut sich Dotierstoff bestimmungsgemäß in den Kristall ein, aber ein großer Teil des Dotierstoffes zusammen mit Sauerstoff, der von einem verwendeten Tiegel aus Quarz verursacht wird, verdampfen in die Atmosphäre in der Kristallziehanlage.

Gemäß dem allgemeinen Stand der Technik transportiert Spülgas, das von oben durch die Kristallziehanlage entlang des zu ziehenden Stabes strömt, den Dotierstoff und den entstandenen Sauerstoff aus der Kristallziehlage durch eine Öffnung ab.

Der Erfinder vermutete, dass dieser Transport von Dotierstoff zusammen mit Sauerstoff in manchen Phasen des Kristallziehens unzureichend ist. Insbesondere im Bereich des Anfangskonus vermutet er, dass das nicht der Fall zu sein scheint und sieht sich in späteren Versuchen bestätigt. Die Versuche bestätigen, dass die Versetzungswahrscheinlichkeit der Kristalle deutlich reduziert wird.

Das erfindungsgemäße Verfahren schlägt vor, den betreffenden Bereich mit einem zweiten Spülgas zu spülen.

Das erfindungsgemäße Verfahren zum Ziehen eines Kristalls aus Silicium mit einem Widerstand von kleiner als 2 mOhmcm nach dem Czochralski-Verfahren enthält damit die folgenden Schritte:
Das in Kontaktbringen eines Impflingskristalls mit einer Schmelze aus Silicium;
das Ziehen eines Dünnhalses enthaltend das Reduzieren des Durchmessers des Impflingskristalls;
das Erweitern des Durchmessers des Dünnhalses zu einem Anfangskonus bis zu einem Zieldurchmesser; und das Ziehen eines zylindrischen Teils des Kristalls mit dem Zieldurchmesser.

Essenziell für das erfindungsgemäße Verfahren ist, dass während des Ziehens des Dünnhalses der Gasraum um den Dünnhals mit einer Entfernung E von minimal 2 cm, bevorzugt minimal 5 cm normal zur Oberfläche des Dünnhalses mit einem zweiten Spülgas gespült wird.

Bevorzugt wird dieser Gasraum auch während des Erweiterns des Durchmessers des Dünnhalses zu einem Anfangskonus mit einem zweiten Spülgas gespült.

Bevorzugt wird das Spülen mittels einer Spüllanze durchgeführt, die ein offenes Ende enthält, durch das das zweite Spülgas fließen kann. Bevorzugt besteht dabei das zweite Spülgas aus Argon.

Der Fluss des zweiten Spülgases durch die Spüllanze beträgt dabei bevorzugt mehr als 0,5 l/min und weniger als 10 l/min. Bevorzugt beträgt die der Fluss mehr als 2 l/min und weniger als 7 l/min.

Besonders bevorzugt besteht die Spüllanze aus Quarzglas.

Ganz besonders bevorzugt ist das offene Ende der Spüllanze so ausgeprägt ist, dass es dafür geeignet ist, den Dünnhals zu umfassen. Erfindungsgemäße Beispiele hierfür sind in **Fig.3** gezeigt.

Ebenfalls bevorzugt ist, dass das eine offene Ende so ausgeformt ist, dass das zweite Spülgas nach unten in Richtung der Schmelze strömen kann. Ausgeführt werden kann das durch geeignete Öffnungen an der Spüllanze (siehe zum Beispiel **Fig. 3**).

## Patentansprüche

1. Verfahren zum Ziehen eines Kristalls aus Silicium mit einem Widerstand von kleiner als 2 mOhmcm nach dem Czochralski-Verfahren enthaltend die Schritte das in Kontaktbringen eines Impflingskristalls **(102)** mit einer dotierten Schmelze aus Silicium **(105)** in einer Kristallziehanlage, wobei das Innere der Kristallziehanlage mit einem ersten Spülgas gespült wird;
das Ziehen eines Dünnhalses **(103)** enthaltend das Reduzieren des Durchmessers des Impflingskristalls **(102)**;
das Erweitern des Durchmessers des Dünnhalses **(103)** zu einem Anfangskonus **(104)** bis zu einem Zieldurchmesser;
und das Ziehen eines zylindrischen Teils des Kristalls mit dem Zieldurchmesser, **dadurch gekennzeichnet, dass**
während des Ziehens des Dünnhalses der Gasraum um den Dünnhals **(103)** mit einer Entfernung E von mehr als 2 cm normal zur Oberfläche des Dünnhalses **(103)** mit einem zweiten Spülgas gespült wird.

2. Verfahren nach Anspruch 1, **dadurch gekennzeichnet, dass** die Entfernung E mehr als 5 cm beträgt.

3. Verfahren nach Anspruch 1, **dadurch gekennzeichnet, dass** das Spülen mittels einer Spüllanze **(206)** enthaltend ein offenes Ende erfolgt, durch das das zweite Spülgas fließen kann.

4. Verfahren nach Anspruch 1, **dadurch gekennzeichnet, dass** das zweite Spülgas aus Argon besteht.

5. Verfahren nach Anspruch 1, **dadurch gekennzeichnet, dass** der Fluss des zweiten Spülgases durch die Spüllanze **(206)** mehr als 0,5 l/min und weniger als 10 l/min beträgt.

6. Verfahren nach Anspruch 5, **dadurch gekennzeichnet, dass** der Fluss des zweiten Spülgases durch die Spüllanze **(206)** mehr als 2 l/min und weniger als 7 l/min beträgt.

7. Verfahren nach Anspruch 3, **dadurch gekennzeichnet, dass** die Spüllanze **(206)** aus Quarzglas besteht.

8. Verfahren nach Anspruch 3, **dadurch gekennzeichnet, dass** das eine offene Ende so ausgeprägt ist, dass es dafür geeignet ist, den Dünnhals **(103)** zu umfassen.

9. Verfahren nach Anspruch 3, **dadurch gekennzeichnet, dass** das eine offene Ende so ausgeformt ist, dass das zweite Spülgas nach unten in Richtung der Schmelze strömen kann.
